Europäisches Patentamt

(19) **European Patent Office**

**Office européen des brevets**

(11) Numéro de publication: **0 093 942**
**B1**

(12) **FASCICULE DE BREVET EUROPEEN**

(45) Date de publication du fascicule du brevet: **20.11.86**

(21) Numéro de dépôt: **83104064.7**

(22) Date de dépôt: **26.04.83**

(51) Int. Cl.⁴: **H 01 S 3/045**

(54) Dispositif de refroidissement d'un laser a semi-conducteur.

(30) Priorité: **30.04.82 FR 8207505**

(43) Date de publication de la demande:
**16.11.83 Bulletin 83/46**

(45) Mention de la délivrance du brevet:
**20.11.86 Bulletin 86/47**

(84) Etats contractants désignés:
**BE DE FR GB IT LU NL**

(56) Documents cités:
**DE-A-2 737 345**
**GB-A-2 054 949**

**PATENTS ABSTRACTS OF JAPAN, vol. 5, no. 145, (E-74)(817), 12 septembre 1981**

**PATENTS ABSTRACTS OF JAPAN, vol. 5, no. 186, (E-84)(858), 25 novembre 1981**

(73) Titulaire: **ALCATEL**
**12, rue de la Baume**
**F-75008 Paris (FR)**

(72) Inventeur: **Allias, Bernard**
**35, rue des Cyprès**
**F-91220 Bretigny Sur Orge (FR)**

(74) Mandataire: **Weinmiller, Jürgen et al**
**Lennéstrasse 9**
**D-8133 Feldafing (DE)**

Courier Press, Leamington Spa, England.

## Description

La présente invention as rapporte aux lasers à semi-conducteur, et plus particulièrement aux dispositifs de refroidissement associés aux lasers à semi-conducteur utilisés dans les équipements de liaisons à fibres optiques, assurant une compensation des dérives en température des lasers à semi-conducteur au cours de leur fonctionnement.

D'une manière courante, les lasers à semi-conducteur nécessitent une alimentation en courant supérieure à une valeur de seuil Is pour l'obtention d'une émission en lumière cohérente. Cette alimentation est réalisée par asservissement d'une source de courant de seuil à la puissance lumineuse émise, au moyen d'une boucle de régulation électrique comprenant essentiellement une photodiode et un amplificateur différentiel commandant ladite source en fonction de l'écart entre la valeur du signal électrique issu de la photodiode et celle d'un signal de référence qu'il reçoit.

Il est également connu qu'à puissance lumineuse émise constante, un laser à semi-conducteur doit être alimenté par un courant supérieur à une valeur de seuil variable en fonction de la température de fonctionnement du laser. La boucle de régulation électrique commandant la source de courant de seuil assure le maintien du courant d'alimentation à une valeur demeurant supérieure à la valeur du courant de seuil variable avec la température de fonctionnement du laser. Le functionnement du laser doit cependant être limité en température, au risque d'une détériorisation directe de celui-ci.

En pratique, en particulier pour des lasers à semi-conducteur susceptibles de fonctionner dans des gammes de température importantes, on associe au laser, en plus de la boucle d'asservissement électrique de son courant d'alimentation, un dispositif de régulation thermique agissant sur sa température au moyen d'un module réfrigérateur qui le maintient à une température suffisamment basse prédéterminée à laquelle les risques de détérioration sont limités.

Un tel dispositif de régulation thermique comporte de manière connue un senseur thermique constitué par une thermistance montée avec le laser dans une enceinte, et un amplificateur différentiel. Cet amplificateur commande le module réfrigérateur en fonction de l'écart entre le signal électrique issu de la thermistance et traduisant la température de l'enceinte, et donc du laser, et un signal de référence traduisant la température souhaitée de l'enceinte, et donc du laser. Le module réfrigérateur utilisé classiquement est un module Peltier alimenté à partir de l'amplificateur de ce dispositif de régulation pour assurer le pompage thermique nécessaire au maintien de l'enceinte et du laser à la température souhaitée.

Si cette régulation thermique des lasers à semi-conducteur peut convenir aux applications où la puissance électrique et la fiabilité notamment demeurent sans inconvéniente majeurs, il en est d'autres, en particulier les répéteurs téléalimentés de liaisons optiques, où ces mêmes paramètres sont d'importance primordials. En effet, dans ces dernières applications, parmi les inconvénients de ce dispositif de régulation thermique on peut citer:

— la nécessité de fournir une puissance électrique propre à ce dispositif de régulation thermique, entraînant un accroissement correspondant de la puissance à fournir aux répéteurs téléalimentés,

— la manque de fiabilité propre au module Peltier, en particulier lors d'un pompage thermique élevé pour la basse température souhaitée de l'enceinte, dans lequel les contraintes mécaniques crées par la différence de température entre la face chaude et la face froide peuvent conduire à des cassures de jonction et, en conséquence, à une défaillance du module entraînant alors la destruction du laser par emballement thermique.

De plus, dans ce mode de régulation thermique du laser, l'enceinte régulée à température définis doit présenter une résistance thermique importante conduisant à un encombrement prohibitif incompatible avec les possibilités dans certaines applications telles qu'équipements de ligne envisagés.

Un dispositif de refroidissement d'une diode laser dans lequel la diode laser et un module de réfrigération thermoélectrique sont branchés en série de façon que le courant circulant dans la diode laser circule également dans le module réfrigérateur est connu de la demande GB—A— 2 054 949.

La présente invention a pour but de pallier les inconvénients cités, en particulier elle a pour but de limiter l'absorption thermique qu'effectue le module réfrigérateur tel qu'un module Peltier, aux seules dérives thermiques de la diode laser par rapport à la température ambiante, ce qui conduit à bénéficier d'une fiabilité accrue du module réfrigérateur.

Elle a donc pour objet un dispositif de refroidissement d'un laser à semi-conducteur alimenté par une source électrique, à module réfrigérateur commandé par un senseur thermique, caractérisé par le fait que ledit module réfrigérateur est commandé par un courant représentatif du seul courant électrique qui traverse le laser, ledit laser constituant ainsi directement et a lui seul ledit senseur thermique pour se propre commande de refroidissement.

Ainsi selon l'invention, c'est le courant laser qui constitue le signal indicateur de température et qui est utilisé pour commander le refroidissement donné par le module réfrigérateur.

De préférence, selon l'invention, la refroidissement du laser est limité à son maintien à la température ambiante, ceci n'entraînant que des contraintes réduites au niveau du module réfrigérateur et évitant, en conséquence, un fonctionnement dans des conditions limites pour lesquelles une défaillance est possible.

L'invention sera décrite ci-après plus en détail à l'aide de plusieurs modes de réalisation illustrés dans le dessin ci-annexé. Dans ce dessin:

— la figure 1 illustre un dispositif de régulation thermique d'un laser à semi-conducteur, selon une technique connue,
— la figure 2 illustre un premier mode de réalisation d'un dispositif de refroidissement selon l'invention,
— la figure 3 illustre un second mode de réalisation d'un dispositif de refroidissement selon l'invention.

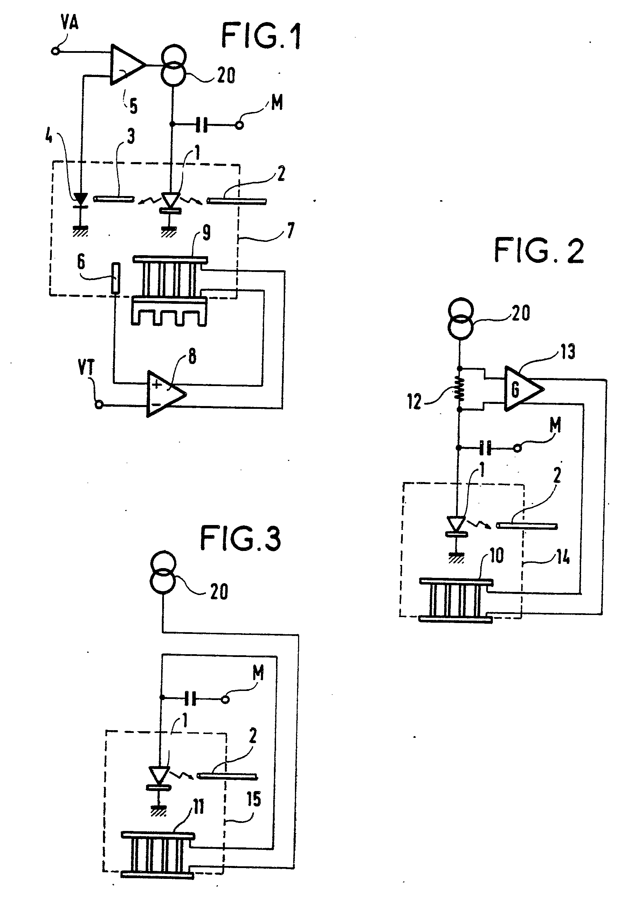

La figure 1 représente un dispositif de régulation d'une source laser 1, de type connu. Le laser 1, symbolisé sous forme d'une diode émettrice, est alimenté à partir d'une source de courant 20 délivrant un courant dit courant de seuil asservi à partir de la puissance lumineuse émise par le laser, pour son émission an lumière cohérante.

On a illustré en 2 une fibre optique de ligne recevant cette lumière cohérente transmise tandis qu'on a illustré en 3 une fibre optique auxiliaire transmettant la lumière émise à une cellule photoélectrique 4.

Une boucle électrique de régulation du courant d'alimentation du laser 1 comporte cette diode photoélectrique 4 et un amplificateur différentiel 5 relié à cette diode et recevant un signal de référence VA. L'écart entre la puissance lumineuse émise par le laser, filtrée par la fibre optique 3 et traduite par un signal de tension, et la puissance lumineuse émise requise pour une émission en lumière cohérente traduite par le signal de référence VA, asservit la source de courant de seuil pour l'alimentation convenable du laser.

Le courant asservi d'alimentation du laser est en outre modulé pour la transmission de données, à partir d'un modulateur, ainsi que symbolisé par la commande M.

A cette boucle électrique de régulation d'alimentation du laser, on associe une boucle de régulation thermique tendant à maintenir le laser dans des conditions définies de température pour lesquelles son courant d'alimentation fourni par la source 20 varie peu. Cette boucle de régulation thermique comporte un senseur thermique 6 monté avec le laser 1 et la diode photoélectrique 4 dans une enceinte 7. Ce senseur thermique constitué par une thermistance est relié à un amplificateur différentiel 8 recevant également un signal de référence VT traduisant la température souhaitée de l'enceinte, donc notamment du laser. Le signal délivré par l'amplificateur différentiel 8 est utilisé pour commander un module réfrigérateur 9 monté dans l'enceinte 7. Ce module réfrigérateur 9 est constitué de manière classique par un module Peltier alimenté par l'amplificateur différentiel 8 pour assurer le pompage thermique nécessaire au maintien de l'enceinte à la température souhaitée définis par le signal de référence VT.

Dans les figures 2 et 3, on illustré deux modes de réalisation du dispositif selon l'invention assurant un simple refroidissement de la diode laser. Dans ces deux figures, le laser 1 est alimenté en courant dont la valeur est supérieure au courant de seuil, par la source 20. Ce courant est modulé par la commande M.

Dans ces deux modes de réalisation conformément à la présente invention, on utilise le courant du laser 1 comme indicateur de température sans assurer, en conséquence, un asservissement de sa température à une basse température fixée mais seulement un refroidissement ou compensation des dérives en température du laser 1 par rapport à la température ambiante, au moyen d'un module réfrigérateur désigné sous la référence 10 dans la figure 2 et sous la référence 11 dans la figure 3 et constitué comme précédemment par un module Peltier.

Dans la réalisation de la figure 2, la représentation du courant laser est prélevée aux bornes d'une résistance 12 montée en série sur la sortie de la source de courant d'alimentation 20. Un amplificateur différential 13 relié aux bornes de cette résistance 12 alimente le module Peltier 10 monté avec le laser 1 et la diode photoélectrique 4 dans une enceinte 14. C'est la représentation du courant laser amplifié qui contrôle le refroidissement réalisé par le module Peltier. Dans cette réalisation, selon le dimensionnement le module Peltier 10 retenu, on choisira le gain G de l'amplificateur 13 pour obtenir un pompage thermique désiré correspondant sensiblement à la chaleur dégagée par le laser.

Selon la réalisation de la figure 3, c'est le courant laser qui traverse directement le module Peltier 11 monté avec le laser 1 dans une enceinte 15. Le module Peltier 11 est électriquement monté en série sur la sortie de la source de courant d'alimentation du laser. Dans cette réalisation, on choisira le nombre de couples semi-conducteurs du module Peltier pour obtenir un pompage thermique désiré correspondant sensiblement à la chaleur dégagée par le laser, ce dimensionnement convenable possible du module Peltier étant alors l'équivalent du gain G de l'amplificateur de commande 13 de la réalisation selon la figure 2.

Dans ces deux montages, le pompage thermique effectué par le module Peltier utilisé est limité à la chaleur dégagée par le laser, ceci en acceptant donc de ne pas le faire fonctionner à une basse température constante, mais à une température voisine de la température ambiante d'utilisation. Plusieurs avantages résultant en conséquence des réalisations conformes à l'invention, en particulier par rapport au montage connu illustré:

— on obtient une indication de température à partir du courant d'alimentation du laser plus rigoureuse que celle donnée par la thermistance du fait du manque de fiabilité de cet élément,

— on obtient un gain de consommation par la suppression de l'amplificateur de la boucle de régulation thermique dont le signal d'alimentation VT constituait la référence de température souhaitée, un gain d'encombrement du fait que l'enceinte actuellement utilisée demeurant à la température ambiante n'a pas à présenter une résistance thermique importante,

— on obtient un fonctionnement du module Peltier dans des conditions de grande fiabilité: en effet, par le seul pompage thermique de la chaleur dégagée par le laser, on réduit l'absorption demandée à ses valeurs minimales. En conséquence, le module Peltier fonctionnera en ne présentant qu'on écart limité entre la température de sa face froide et de sa face chaude pour lequel les contraintes mécaniques sur le module sont faibles et lui sont nullement préjudiciables.

Dans ces deux montages, la compensation des dérives thermiques, réalisée avec une bonne précision en raison de l'indication rigoureuse de température donnée à partir du courant traversant la diode laser et dans de bonnes conditions de fiabilité en raison de l'absorption thermique réduite demandée au module Peltier, réduit les dérives de la puissance lumineuse émise par la diode laser. Cette compensation thermique peut à elle seule permettre d'éviter l'utilisation de toute boucle de régulation électrique du courant d'alimentation de la diode laser choisie stable en température et conduire; ainsi qu'il ressort des figures 2 et 3, à une extrême simplicité de réalisation.

## Revendications

1. Dispositif de refroidissement d'un laser à semi-conducteur alimenté par une source électrique, à module réfrigérateur commandé par un senseur thermique, caractérisé par le fait que ledit module réfrigérateur (10, 11) est commandé par un courant représentatif du seul courant électrique qui traverse le laser (1), ledit laser constituant ainsi directement et à lui seul ledit senseur thermique pour sa propre commande de refroidissement.

2. Dispositif de refroidissement selon la revendication 1, caractérisé en ce qu'il comporte une résistance (12) reliée, en série avec le laser (1), à la source électrique d'alimentation (20) et un amplificateur différentiel (13) monté aux bornes de ladite résistance et commandant ledit module réfrigérateur (10).

3. Dispositif de refroidissement selon la revendication 2, caractérisé en ce que ledit amplificateur différentiel (13) est de gain choisi en fonction du dimensionnement dudit module réfrigérateur (10), pour que ledit module ne réalise qu'un pompage thermique limité à un refroidissement défini initialement du laser (1).

4. Dispositif de refroidissement selon la revendication 3, caractérisé par le fait que le gain dudit amplificateur (13) est choisi pour que le pompage thermique soit sensiblement équivalent à la chaleur dégagée par le laser (1) pour un fonctionnement de ce dernier à une température voisine de la température ambiante d'utilisation.

5. Dispositif de refroidissement selon la revendication 1, caractérisé en ce que ledit module réfrigérateur (11) est monté électriquement en série avec le laser (1) et la source électrique d'alimentation (20).

6. Dispositif de refroidissement selon la revendication 5, caractérisé en ce que ledit module réfrigérateur (11) traversé par le courant laser est dimensionné pour obtenir un pompage thermique limité à un refroidissement défini initialement du laser.

7. Dispositif de refroidissement selon la revendication 6, caractérisé par le fait que ledit module réfrigérateur (11) est dimensionné pour que le pompage thermique soit sensiblement équivalent à la chaleur dégagée par le laser (1) pour un fonctionnement de ce dernier à une température voisine de la température ambiante d'utilisation.

## Patentansprüche

1. Kühlvorrichtung für einen von einer Stromquelle gespeisten Halbleiterlaser mit von einer Wärmesonde gesteuertem Kühlmodul, dadurch gekennzeichnet, daß der Kühlmodul (10, 11) von einem Strom gesteuert wird, der nur für den elektrischen Strom repräsentativ ist, der den Laser (1) durchquert, so daß der Laser direkt und ganz alleine die Wärmesonde für seine eigene Kühlsteuerung bildet.

2. Kühlvorrichtung nach Anspruch 1, dadurch gekennzeichnet, daß sie einen Widerstand (12), der in Reihe mit dem Laser (1) an die elektrische Speisequelle (20) angeschlossen ist, und einen Differentialverstärker (13) aufweist, der an den Klemmen des Widerstands liegt und den Kühlmodul (10) steuert.

3. Kühlvorrichtung nach Anspruch 2, dadurch gekennzeichnet, daß die Verstärkung des Differentialverstärkers (13) in Abhängigkeit von den Abmessungen des Kühlmoduls (10) so gewählt ist, daß der Modul nur eine Wärmeabfuhr durchführt, die auf eine vorab definierte Kühlung des Lasers (1) begrenzt ist.

4. Kühlvorrichtung nach Anspruch 3, dadurch gekennzeichnet, daß die Verstärkung des Verstärkers (13) so gewählt ist, daß die Wärmeabfuhr im wesentlichen gleich der vom laser (1) abgegebenen Wärme ist, wenn dieser bei einer der Verwendungs-Umgebungstemperatur nahen Temperatur arbeitet.

5. Kühlvorrichtung nach Anspruch 1, dadurch gekennzeichnet, daß der Kühlmodul (11) elektrisch in Reihe mit dem Laser (1) und der elektrischen Speisequelle (20) angeordnet ist.

6. Kühlvorrichtung nach Anspruch 5, dadurch gekennzeichnet, daß der vom Laserstrom durchquerte Kühlmodul (11) so dimensioniert ist, daß ein auf eine vorab definierte Abkühlung des Lasers begrenztes Wärmeabfuhr erhalten wird.

7. Kühlvorrichtung nach Anspruch 6, dadurch gekennzeichnet, daß der Kühlmodul (11) so dimensioniert ist, daß die Wärmeabfuhr im wesentlichen gleich der vom Laser (1) abgegebenen Wärme ist, wenn dieser bei einer der Verwendungs-Umgebungstemperatur nahen Temperatur arbeitet.

**Claims**

1. A cooling device for a semiconductor laser fed by an electrical supply source, comprising a refrigerator module which is controlled by a thermal probe, characterized in that said refrigerator module (10, 11) is controlled by a current which is representative only of the electric current passing through the laser (1), said laser thus constituting directly and exclusively said thermal probe for its own cooling control.

2. A cooling device according to claim 1, characterized in that it comprises a resistor (12) connected in series with the laser (1) and the electrical supply source (20), and a differential amplifier (13) connected to the terminals of said resistor and controlling said refrigerator module (10).

3. A cooling device according to claim 2, characterized in that the gain of said differential amplifier (13) is chosen in dependence of the size of said refrigerator module (10) so that said module only pumps a limited amount of heat corresponding to an intially defined cooling of the laser (1).

4. A cooling device according to claim 3, characterized in that the gain of said amplifier (13) is chosen so that the heat pumped is substantially equivalent to the heat produced by the laser (1) when operating at a temperature close to the ambient temperature at which it is used.

5. A cooling device according to claim 1, characterized in that said refrigerator module (11) is connected electrically in series with the laser (1) and the electrical supply source (20).

6. A cooling device according to claim 5, characterized in that said refrigerator module (11) through which the laser current passes, is of such a size that said module only pumps a limited amount of heat to ensure an initially defined cooling of the laser.

7. A cooling device according to claim 6, characterized in that said refrigerator module (11) is of such a size that the heat pumped is substantially equivalent to the heat produced by the laser (1) when operating at a temperature close to the ambient temperature at which it is used.

# FIG.1

VA

20

5

M

4

3

1

2

7

9

6

VT

8

# FIG. 2

20

13

G

12

M

1

2

10

14

# FIG.3

20

M

1

2

11

15